# EUROPÄISCHE PATENTANMELDUNG

(11) **EP 4 776 433 A1**
(43) Veröffentlichungstag der Anmeldung: **15.07.2026**
(21) Anmeldenummer: 25151396.6
(22) Anmeldetag: 13.01.2025
(51) Int. Cl.: H01R 12/51, H01R 12/58, H01R 4/30, H05K 3/30, H01R 101/00

(54) **HOCHSTROMKONTAKT UND HALBLEITERLEISTUNGSRELAIS MIT HOCHSTROMKONTAKT**

(71) Anmelder: Kliem, Thomas, 78628 Rottweil (DE)
(72) Erfinder: Kliem, Thomas, 78628 Rottweil (DE)
(74) Vertreter: Düsselberg, David

(57) **Zusammenfassung**

Die Erfindung betrifft einen Hochstromkontakt (1) zur elektrischen Verbindung einer Leiterplatte (18, 20) eines Halbleiterleistungsrelais (24) mit einem externen Stromkreis, insbesondere dem Bordnetz eines Kraftfahrzeugs, gebildet aus einem dreidimensionalen Grundkörper (2), dessen Länge seine übrigen Abmessungen übersteigt, wobei der Grundkörper ein in Längsrichtung erstes freies Ende (3) und ein dem ersten freien Ende gegenüber liegendes zweites freies Ende (4) aufweist, wobei das erste freie Ende der elektrischen Verbindung mit der Leiterplatte dient und wobei das zweite freie Ende der elektrischen Verbindung mit dem externen Stromkreis dient, wobei das erste freie Ende mit polyedrischer Form, ausgebildet ist, **dadurch gekennzeichnet, dass** das erste freie Ende zur elektrischen Verbindung mit der Leiterplatte wenigstens zwei elektrisch leitfähige Kontaktelemente (8) aufweist, die sich jeweils von einer der Polyederfläche (6) des ersten freien Endes aus in voneinander verschiedene Raumrichtungen erstrecken.

Ferner betrifft die Erfindung ein Halbleiterleistungsrelais mit wenigstens einem Hochstromkontakt gemäß der Erfindung sowie ein System.

## Beschreibung

Die Erfindung betrifft einen Hochstromkontakt zur elektrischen Verbindung einer Leiterplatte eines Halbleiterleistungsrelais mit einem externen Stromkreis, insbesondere dem elektrischen Bordnetz eines Kraftfahrzeugs. Ferner betrifft die Erfindung ein Halbleiterleistungsrelais mit einem mit einer Leiterplatte elektrisch verbundenen erfindungsgemäßen Hochstromkontakt.

Im technischen Bereich der Fahrzeugelektronik werden zur Schaltung von hohen Strömen zwischen 50A und 1000A mit Spannungsbereichen von 12V, 24V, 48V, 60V oder 80V kontaktbehaftete, mechanische Leistungsrelais eingesetzt. Mechanische Leistungsrelais sind im Kern aus einem Permanentmagneten, einem beweglichen Kontakt und einer elektrischen Spulenanordnung gebildet.

Mechanische Leistungsrelais haben jedoch eine Reihe von Nachteilen. Sie haben insbesondere eine begrenzte Anzahl von Schaltzyklen, welche bei ungünstig zu schaltenden Lasten wenige 1000 Schaltzyklen betragen kann. Weitere Nachteile sind die Anfälligkeit gegenüber Einschaltströmen und Spannungsspitzen, die geringe Vibrations- und Schockresistenz sowie die vergleichsweise hohe Wärmeentwicklung, welche gesonderte Kühlmaßnahmen erfordert. Auch lassen sich mechanische Leistungsrelais hinsichtlich ihres Leistungsdaten schlecht skalieren und an bestimmte elektrische Kennwerte baulich anpassen. Darüber hinaus benötigt ein mechanisches Leistungsrelais einen vergleichsweise hohen Spulenstrom sowie zur Schaltung eine Spannung die im Wesentlichen der Nennspannung entspricht.

Darüber hinaus sind aus dem Kraftfahrzeugbereich Halbleiterrelais bekannt, die für verschiedene Anwendungen im Niederstrombereich genutzt werden. Hierzu zählen beispielsweise Blinkerrelais als Taktgeber für die Blinkleuchte oder Intervallrelais zur Steuerung von Scheibenwischerintervallen. Halbleiterrelais sind keine mechanischen Relais, sondern elektronische Bauelemente, die ohne bewegte Kontakte schalten. Sie werden in der Regel mit Transistoren wie etwa Feld-Effekt-Transistoren (FET) realisiert.

Im Gegensatz zu mechanischen Leistungsrelais verfügen Halbleiterrelais über nahezu unbegrenzte Schaltzyklen, können mit hohen Einschaltströmen oder Spannungsspitzen belastet werden, weisen eine hohe Vibrations- und Schockresistenz und entwickeln aufgrund der geringen Leistungsaufnahme bei der Ansteuerung nur eine geringe Eigenwärme, wodurch auf gesonderte Kühlmaßnahmen verzichtet werden kann.

Aufgrund dieser Vorteile besteht mithin das prinzipielle industrielle Bestreben, mechanische Leistungsrelais durch halbleiterbasierte Leistungsrelais, kurz Halbleiterleistungsrelais, zu ersetzen. Dies ist jedoch bislang an verschiedenen Problemen gescheitert, die insbesondere die Verbindung zwischen Hochstromkontakt und Leiterplatte einerseits und zwischen Hochstromkontakt und KFZ-Bordelektronik andererseits betreffen.

Im Allgemeinen sind Hochstromkontakte bekannt und werden aufgrund ihrer guten elektrischen Eigenschaften dazu verwendet, hohe Ströme zu übertragen. Diese reichen typischerweise von einigen Ampere bis zu einigen hundert Ampere. Ebenso eignen Sie sich für die Einspeisung hoher Gleich- und Wechselspannungen. Auf dem Markt verfügbare Hochstromkontakte haben sich jedoch mit Blick auf den angestrebten Ersatz von mechanischen Leistungsrelais als funktional wenig flexibel erwiesen.

Der Erfindung liegt damit die **Aufgabe** zugrunde, einen Hochstromkontakt einerseits und Halbleiterleistungsrelais, bereitzustellen, welches auf Halbleitertechnik basiert und den Ersatz von mechanischen Leistungsrelais insbesondere im Kraftfahrzeugbereich erlaubt.

Zur **Lösung** der Aufgabe wird mit der Erfindung ein Hochstromkontakt zur elektrischen Verbindung einer Leiterplatte eines Halbleiterleistungsrelais mit einem externen Stromkreis, insbesondere dem Bordnetz eines Kraftfahrzeugs, vorgeschlagen, gebildet aus einem dreidimensionalen Grundkörper, dessen Länge seine übrigen Abmessungen übersteigt, wobei der Grundkörper ein in Längsrichtung erstes freies Ende und ein dem ersten freien Ende gegenüber liegendes zweites freies Ende aufweist, wobei das erste freie Ende der elektrischen Verbindung mit der Leiterplatte dient und wobei das zweite freie Ende der elektrischen Verbindung mit dem externen Stromkreis dient, wobei das erste freie Ende mit polyedrischer Form, ausgebildet ist, dadurch gekennzeichnet, dass das erste freie Ende zur elektrischen Verbindung mit der Leiterplatte wenigstens zwei elektrisch leitfähige Kontaktelemente aufweist, die sich jeweils von einer der Polyederfläche des ersten freien Endes aus in voneinander verschiedene Raumrichtungen erstrecken.

Ferner wird zur **Lösung** der Aufgabe vorgeschlagen ein Halbleiterleistungsrelais, insbesondere KFZ-Halbleiterleistungsrelais, mit wenigstens einem Hochstromkontakt nach einem der Ansprüche 1 bis 12, wenigstens einer Leistungstransistorschaltung und einem Gehäuse zur Aufnahme des Hochstromkontakts und der Leistungstransistorschaltung, wobei die Leistungstransistorschaltung wenigstens zwei mittels des Hochstromkontakts parallel geschaltete Leistungstransistoren, insbesondere in Form von Leistungs-MOSFETs, aufweist, wobei die wenigstens zwei Leistungstransistoren auf einer einzigen, insbesondere dreidimensionalen, Leiterplatte oder zwei verschiedenen Leiterplatten angeordnet sind, wobei jeder Leistungstransistor leitungstechnisch mit einem eigenen flächigen Kontaktabschnitt verbunden ist, der von der wenigstens einen Leiterplatte bereitgestellt ist, wobei jeweils ein Kontaktabschnitt jeweils einer freien Polyederfläche, insbesondere Quaderfläche, des ersten freien Endes des Hochstromkontakts zugeordnet und mit dieser durch zumindest eines jeweiligen Kontaktelemente mechanisch und leitungstechnisch durch Löten, verschrauben oder Einpressen verbunden ist.

Durch die Erfindung ist es nun erstmals möglich, die im KFZ-Elektronikbereich bislang eingesetzten mechanischen kontaktbehafteten Leistungsrelais durch Halbleiterleistungsrelais zu ersetzen. Dies wird im ersten Schritt durch den erfindungsgemäßen Hochstromkontakt erreicht, welcher einerseits mit seinem zweiten freien Ende einen bordnetzkompatiblen Relaisanschluss bereitstellt, der hinsichtlich Geometrie, Abmessung und Leistungsaufnahme demjenigen der bisher verwendeten mechanischen Relais entspricht. Auf einen für ein mechanisches Leistungsrelais vorgesehen Bordnetzanschluss kann nun das Halbleiterleistungsrelais mittels des zweiten freien Endes des Hochstromkontakts aufgesteckt bzw. aufgeschraubt werden. Darüber hinaus ist es nun erstmals möglich, Halbleiterleistungsrelais in nahezu beliebiger Weise für Hochstromanwendungen zu skalieren. Erreicht wird dies, indem der Hochstromkontakt mit seinem ersten freien Ende mehr als einen Anschluss für Leiterplatten bereitstellt. Hierdurch können wenigstens zwei, vorzugsweise jedoch mehrere Leistungstransistoren parallelgeschaltet werden. Dies kann dadurch erfolgen, dass auf einer einzigen dreidimensionalen Leiterplatte zwei oder mehr Leistungstransistoren angeordnet und mittels der Kontaktelemente der verschiedenen freien Quaderflächen leitungstechnisch mit dem externen Stromkreis, insbesondere dem Bordnetz, verbunden werden. Die Parallelschaltung wird durch eine entsprechende Leitungsführung auf der Leiterplatte realisiert. Zusätzlich zu dieser Möglichkeit oder auch alternativ dazu können Leistungstransistoren auf verschiedenen Leiterplatten angeordnet sein. In diesem Fall lassen sich die verschiedenen Leiterplatten mittels des ersten freien Endes des Hochstromkontakts parallelschalten. Auf diese Weise ist es dem erfindungsgemäßen Halbleiterleistungsrelais möglich, besonders hohe Ströme zu schalten und durch entsprechende Parallelschaltung in Abhängigkeit der zu schaltenden Stromstärken skaliert zu werden. Dies wird insbesondere durch die innovative geometrische Struktur und Form des ersten freien Endes ermöglich, da die winklig zueinanderstehenden freien Quaderflächen den Anschluss von Leiterplatten in drei Dimensionen erlaubt. Ein weiterer Vorteil der Erfindung ist, dass besonders kurze Leitungswege zwischen den Kontaktflächen der Leiterplatte und dem Leistungstransistor-Bauelement realisierbar sind. Hierdurch werden übermäßige Spannungsabfälle und Wärmeentwicklung aufgrund von Leitungswiderständen vermieden. Diese kurzen Leitungswege werden wiederum aufgrund der Geometrie des ersten freien Endes des Hochstromkontakts realisierbar, da die Anordnung von Kontaktflächen, Leitungswegen und Transistor-Bauelementen auf einer oder mehreren Leiterplatten unmittelbar nebeneinander erfolgen kann. Darüber hinaus können aufgrund der kurzen Wege erforderliche EMV- und ESD-Schutzbausteine unmittelbar an den Kontaktflächen angeordnet werden, wodurch diese besonders wirksam sind.

Ein "Hochstrom" meint im Sinne der Erfindung Ströme mit Stromstärken zwischen 50 A und 1000 A.

"Halbleiterleistungsrelais" meint im Sinne der Erfindung ein diskretes Bauteil, welches eine elektronische Schaltung aufnimmt, die als wesentliches Funktionselement einen oder mehrere Leistungstransistoren, insbesondere einen Leistungs-MOSFET, aufnimmt. Es verfügt über wenigstens einen elektrischen Kontakt, der mit einem externen Stromkreis leitungstechnisch verbindbar ist und vorzugsweise auf einen korrespondieren Anschluss bspw. ein den externen Stromkreis bereitstellendes Bordnetz eines Kraftfahrzeugs verliersicher montierbar ist.

Der Begriff "Leistungstransistor" bezeichnet im Sinne der Erfindung ein Transistor zum Schalten oder Steuern von Strömen zwischen 50 A und 1000 A. Sie unterscheiden sich von üblichen Transistoren in ihrem Aufbau insbesondere durch ihre geometrische Form und Dimension.

Der Begriff "Leistungs-MOSFET" bezeichnet im Sinne der Erfindung eine Sonderform des Leistungstransistors. "MOSFET" steht für "metal oxide semiconductor field-effect transistor" bzw. "Metall-Oxid-Halbleiter-Feldeffekttransistor" und ist eine Bauform eines Transistors. Innerhalb der Feldeffekttransistoren zeichnen sich MOSFETs durch ein isoliertes Gate aus einem Oxid aus und gehören damit zu den Feldeffekttransistoren mit isoliertem Gate (IGFET) bzw. Metall-Isolator-Halbleiter-Feldeffekttransistoren (MISFET). MOSFETs basieren auf einer Metall-Isolator-Halbleiter-Struktur, d. h. einem schichtweisen Aufbau aus einer isolierten Gate-Elektrode aus Metall oder hochdotiertem Polysilizium, einem Halbleiter und dem dazwischen befindlichen oxidischen Dielektrikum. Die Steuerung des Stromflusses im Halbleiterbereich erfolgt zwischen den beiden elektrischen Anschlüssen Drain und Source über eine elektrische Steuerspannung (Gate-Source-Spannung) bzw. Steuerpotential (Gate-Potential). Auch der Aufbau des Leistungs-MOSFET entspricht im Prinzip dem des MOSFET Die hohe Leistungsdichte wird bei Leistungs-MOSFETs jedoch durch eine raster- oder wabenartige Halbleiterstruktur erreicht, die einer Parallelschaltung von tausenden einzelnen MOSFETs entspricht. Dies wird dadurch ermöglicht, dass sich MOSFETs bei niedrigen Schaltfrequenzen nahezu leistungslos steuern lassen, da lediglich zum Umladen der Gatekapazität impulsweise Steuerströme benötigt werden. Der beim eingeschalteten Transistor verbleibende Widerstand verursacht eine Verlustleistung und besitzt einen positiven Temperaturkoeffizienten, weshalb MOSFETs parallelgeschaltet werden können.

"Polyeder", "polyedrisch" oder "polyedrische Form" bezeichnet im Sinne der Erfindung ist ein dreidimensionaler Körper, der ausschließlich von ebenen Flächen begrenzt wird. Hierzu zählen vorzugsweise die fünf platonischen Körper Tetraeder, Hexaeder, Oktaeder, Dodekaeder und Ikosaeder, aber auch insbesondere der Quader als allgemeinere Form des platonischen Hexaeders oder Pyramiden mit polygonaler Grundfläche, insbesondere quadratischer Grundfläche. "Quader" bezeichnet im Sinne der Erfindung einen geometrischen Körper, der von 6 Rechtecken begrenzt wird. Er besitzt sechs rechteckige Seitenflächen, die im rechten Winkel aufeinander stehen, und vorliegend als "Quaderflächen" bezeichnet werden, acht rechtwinklige Ecken und 12 Kanten, von denen jeweils vier gleiche Längen besitzen, zueinander parallel sind und vorliegend als "Quaderkanten" bezeichnet werden. Gegenüberliegende Seitenflächen eines Quaders sind parallel und deckungsgleich. Im Sonderfall gleicher Kantenlängen, bei dem alle Seitenflächen des Quaders Quadrate sind, ergibt sich im Sinne der Erfindung einen Kubus, also einen platonischen Hexaeder.

Gemäß einem bevorzugten Merkmal der Erfindung ist jedes Kontaktelement auf einer separaten Polyederseite angeordnet ist und sich entlang der Flächennormalen der jeweiligen Polyederfläche erstreckt. In vorteilhafter Weise kann dann der leiterplattenseitige Anschluss an den Hochstromkontakt damit an verschiedenen Seiten des Polyeders erfolgen, wodurch insbesondere die Anordnung von zwei oder mehr Leiterplatten aufgrund der räumlichen Trennung der Anschlüsse erleichtert ist.

Gemäß einem bevorzugten Merkmal der Erfindung sind die Kontaktelemente jeweils durch wenigstens einen Schraubkontakt, einen Lötstift oder einen Einpressstift gebildet. Jede der vorgenannten Anschlussformen ist möglich und kann in Abhängigkeit der konkreten Schaltungsausgestaltung ausgewählt werden. Die Ausgestaltung als Einpresskontakt ist im Kontext der Erfindung bevorzugt.

Gemäß einem bevorzugten Merkmal der Erfindung ist vorgesehen, dass das erste freie Ende mit polyedrischer, insbesondere quaderförmiger, Form ausgebildet ist, wobei eine der Polyederflächen, insbesondere der sechs Quaderflächen, des ersten Endes mit dem zweiten freien Ende verbunden ist und die übrigen Polyederflächen, insbesondere die übrigen fünf Quaderflächen, freie Polyederflächen, insbesondere Quaderflächen, bilden, wobei wenigstens zwei der freien Polyederflächen, insbesondere Quaderflächen, jeweils eine Vielzahl von Kontaktelementen in Form von Löt- und/oder Einpressstiften aufweisen, die lotrecht auf der jeweiligen freien Polyederfläche, insbesondere Quaderfläche, stehen und innerhalb eines vorgebbaren Flächenabschnitts der jeweiligen Polyederfläche, insbesondere Quaderfläche, regelmäßig verteilt angeordnet sind.

Vorzugsweise ist vorgesehen, dass das erste freie Ende quaderförmig ausgebildet ist. Dabei sind bevorzugt wenigstens zwei freie Quaderflächen mit einer Vielzahl von Kontaktelementen bestückt. Dies ermöglicht die Parallelschaltung wenigstens zweier Leistungstransistoren auf einer oder verschiedenen Leiterplatten mit den erfindungsgemäßen Vorteilen. Je nachdem welche der freien Quaderflächen mit Kontaktelementen bestück sind, ergeben sich verschiedene Vorteile.

Gemäß einer ersten bevorzugten Ausgestaltung sind die beiden mit Kontaktelementen bestückten freien Quaderflächen einander gegenüberliegend angeordnet. Dies erleichtert die Verbindung des ersten freien Endes mit zwei zweidimensionalen Leiterplatten. Diese können, ohne sich im Raum zu blockieren an gegenüberliegenden Seiten des Quaders angeordnet und über die jeweiligen Kontaktelemente leitungstechnisch verbunden und mechanisch befestigt werden. Hierbei ergibt sich im Ergebnis eine Anordnung aus zwei zweidimensionalen Leiterplatten und einen zwischengeordneten Hochstromkontakt, bei dem die beiden flächigen Ebenen der Leiterplatten zueinander parallel verlaufen.

Gemäß einer zweiten bevorzugten Ausgestaltung ist vorzugsweise vorgesehen, dass die beiden mit Kontaktelementen bestückten freien Quaderflächen eine gemeinsame Quaderkante zwischen sich ausbilden und sich im rechten Winkel zueinander erstrecken. Durch diese winklige Ausgestaltung der freien Quaderflächen und korrespondierenden Kontaktelemente erlaubt die einfachste dreidimensionale Ausgestaltung der Leiterplatte mit einfach gewinkeltem Querschnitt und erlaubt überdies den Anschluss des Hochstromkontakts an den Leiterplatten mittels Einpresstechnik. Dies deshalb, da im vorliegenden Fall die den jeweils mit Kontaktelementen bestückten Quaderflächen gegenüberliegenden Quaderflächen kontaktelementfrei ausgebildet sein können und damit der Kraftaufnahme und Kontaktierung mit einem Einpresswerkzeug, etwa in Form eines Pressstempels dienen können. Die Presskraft kann in diesem Fall linear auf den Hochstromkontakt gelegt werden, wodurch eine unerwünschte mechanische Beanspruchung der Einpressstifte quer zur deren jeweiliger Einpressrichtung vermieden wird. Als "Einpresstechnik" bezeichnet man eine lötfreie Verbindungstechnik bei Leiterplatten, bei der ein Kontaktstift, vorliegend als "Einpressstift" bezeichnet, in das metallisierte Loch einer Leiterplatte gedrückt wird. Hierdurch kann auf zusätzliche mechanische Befestigung verzichtet werden. Vorzugsweise wird die sogenannte massive Einpresstechnik (MPFT) eingesetzt. Hierzu sind die Einpressstifte als massive quadratische Pins ausgebildet. Die Diagonale des Stiftquerschnitts ist größer als der Durchmesser des Lochs in der Leiterplatte. Durch das Einpressen der Kontaktstiftkanten in die Metallisierung der Durchkontaktierung der Leiterplatte entsteht eine gasdichte Kaltschweißverbindung über die Länge der Durchkontaktierung, die sich bei bestimmungsgemäßer Ausführung durch eine sehr hoher Stromtragfähigkeit sowie hohe Zuverlässigkeit und Langlebigkeit auszeichnet.

Gemäß einem weiteren bevorzugten Merkmal der Erfindung ist vorgesehen, dass eine der mit Kontaktelementen bestückten freien Quaderflächen derjenigen Quaderfläche gegenüberliegend angeordnet ist, die mit dem zweiten freien Ende verbunden ist. Der Vorteil dieser weitergebildeten Ausführungsform der gewinkelten Ausrichtung der mit Kontaktelementen bestückten freien Quaderflächen liegt darin, dass das zweite Ende als Kraftaufnahmeabschnitt für die Einpresstechnik genutzt werden kann, was zu einer besonders günstigen Krafteinleitung führt.

Gemäß einem bevorzugten Merkmal der Erfindung ist vorgesehen, dass mehr als nur zwei freie Quaderflächen mit Kontaktelementen bestückt sind. Je mehr freie Quaderflächen bestückt sind, desto höher können die zu schaltenden Ströme sein, da im Ergebnis mehr Leistungstransistoren parallelgeschaltet werden können. Um eine an den konkreten Anwendungsfall angepasste Skalierung zu erreichen können 3, 4 oder alle 5 freien Quaderflächen mit Kontaktelementen bestückt und leitungstechnisch über das zweite freie Ende mit dem externen Stromkreis elektrisch verbindbar sein. Aus der Anzahl der zur Kontaktierung nutzbaren freien Quaderflächen ergeben sich eine Vielzahl von leiterplattenseitigen Schaltungsmöglichkeiten. Dabei können bis zu fünf zweidimensionale Leiterplatten mittels des Hochstromkontakts leitungstechnisch verbunden werden. Alternativ kann eine entsprechend ausgebildete dreidimensionale Leiterplatte an bis zu fünf Kontaktabschnitten mit dem Hochstromkontakt leitungstechnisch verbunden werden. Auch eine kombinierte Ausgestaltung einer leitungstechnischen Verbindung des Hochstromkontakts mit zweidimensionalen und dreidimensionalen Leiterplatten ist möglich und bevorzugt. Besonders bevorzugt ist, dass alle fünf freien Quaderflächen jeweils eine Vielzahl von elektrischen Kontaktelementen in Form von Löt- und/oder Einpressstiften aufweisen, die lotrecht auf der jeweiligen freien Quaderfläche stehen und innerhalb eines vorgebbaren Flächenabschnitts der jeweiligen Quaderfläche regelmäßig verteilt angeordnet sind.

Die Bezeichnung "Flächenabschnitt" umfasst im Sinne der Erfindung die gesamte Fläche oder nur einen Teil davon. Sofern ein Teil gemeint ist, weist der Flächenabschnitt einen rechteckigen Umfang auf. Die Fläche eines Flächenabschnitts der mit Kontaktelementen bestückt ist, kann insbesondere zwischen 25% und 75%, insbesondere 40% bis 60%, vorzugsweise 45% bis 55%, besonders bevorzugt 50%, der Gesamtfläche betragen. Ferner ist es bevorzugt, dass ein umlaufender freier Rand gebildet ist, der frei von Kontaktelementen ist. Der hat vorzugsweise eine Breite die der Breite (im Fall von Kontaktelementen mit eckigem Querschnitt) bzw. dem Durchmesser (im Fall von Kontaktelementen mit kreisförmigem Querschnitt) eines Kontaktelements entspricht. Vorzugsweise beträgt die Breite des freien Randes dabei zwischen 0,5 mm und 1 mm. Hierdurch kann der Rand als Auflagefläche für ein Presswerkzeug bei der Einpresstechnik genutzt werden, ohne dass die äußeren Kontaktelemente beschädigt werden, insbesondere abknicken oder verbiegen. Alternativ kann auch beim Einpressen auf den umlaufenden Rand verzichtet und die äußeren Kontaktelemente randbündig im Flächenabschnitt platziert werden. In diesem Fall kann beispielsweise über die Kontaktelemente direkt eingepresst werden, insbesondere dann, wenn die Kontaktelemente als massive Einpressstifte mit rechteckigem, insbesondere quadratischem, oder rundem, insbesondere kreisförmigem, Querschnitt gebildet sind.

Gemäß einer bevorzugten Ausführungsform der Erfindung ist vorgesehen, dass eine freie Quaderfläche, die einer mit Kontaktelementen in Form von Einpressstiften bestückten Quaderfläche gegenüberliegend angeordnet ist, einen kontaktelementfreien Flächenabschnitt aufweist, welcher der Kraftaufnahme und der diesbezüglichen Kontaktierung mit einem Presswerkzeug während des Einpressens der Kontaktelemente der gegenüberliegenden freien Quaderfläche in die Leiterplatte dient. um Beschädigungen an den Kontaktelementen zu vermeiden ist es bei der Einpressung wesentlich, dass diese jeweils in axialer Richtung mit Presskraft beaufschlagt werden. Der jeweils gegenüberliegende kontaktelementfreie Flächenabschnitt kann hierfür in vorteilhafter Weise genutzt werden, indem das Presswerkzeug dort ansetzt. Es ist nicht erforderlich, dass der dafür genutzte kontaktelementfreie Flächenabschnitt die gesamte Fläche der freien Quaderfläche einnimmt. Vielmehr kann es vorgesehen sein, dass eine freie Quaderfläche sowohl einen mit Kontaktelementen bestückten ersten Flächenabschnitt und einen kontaktelementfreien zweiten Flächenabschnitt aufweist. Auf diese Weise kann die freie Quaderfläche sowohl für den leiterplattenseitiger Anschluss als auch für die Einpressung gegenüberliegender Einpressstifte genutzt werden. Dies ermöglicht es insbesondere, dass das erste freie Ende auch dann der Einpresstechnik zugänglich ist, wenn alle fünf freien Quaderflächen mit Einpressstiften bestückt sind.

Gemäß einer alternativen Ausgestaltung ist vorgesehen, dass der mit Kontaktelementen bestückte Flächenabschnitt die gesamte freie Quaderfläche zweier einander gegenüberliegender freier Quaderflächen einnimmt. Auch in diesem Fall ist ein Einpressen der Kontaktelementen möglich. Dabei wird vorzugsweise mit dem Pressstempel unmittelbar auf die Kontaktelemente gedrückt. Dies ist insbesondere dann möglich und bevorzugt, wenn die Kontaktelemente eine gewisse Eigenstabilität in axialer Richtung aufweisen. Dies ist insbesondere dann der Fall, wenn die Kontaktelemente als massive Einpressstifte mit rechteckigem, insbesondere quadratischem, oder rundem, insbesondere kreisförmigem, Querschnitt gebildet sind.

Gemäß einem bevorzugten Merkmal der Erfindung ist vorgesehen, dass in den Grundkörper eine Leistungsleitung zur elektrischen Ansteuerung eines Leistungstransistors auf der Leiterplatte des Halbleiterleistungsrelais und eine Signalleitung für die datentechnische Verbindung mit Diagnoseeinheiten integriert sind, wobei für die jeweilige Verbindung Kontaktelemente verschiedener freier Polyederflächen, insbesondere Quaderflächen, und/oder einzelne Kontaktelemente und/oder eine Mehrzahl von Kontaktelementen der gleichen Polyederfläche, insbesondere Quaderfläche, zu wenigstens einer Leistungsleitungsgruppe und einer Diagnoseleitungsgruppe gruppiert sind. Der Hochstromkontakt bündelt damit verschiedene Funktionen. Hierdurch entfallen separate Baugruppen, wodurch Platz auf der Leiterkarte für anderes frei wird. Darüber hinaus können auf diesem Wege verschiedenste Diagnosedaten und elektrische Kennwerte über den Hochstromkontakt und/oder die Leistungstransistorschaltung erhalten und ausgewertet werden. Es ist in diesem Zusammenhang bevorzugt, dass das erste freie Ende des Grundkörpers mehrteilig ausgebildet ist. Die einzelnen Teile sind dabei derart miteinander verbunden, dass sie zusammengenommen die Quaderform des ersten freien Endes ausbilden. Ferner ist bevorzugt vorgesehen, dass die jeweiligen Teilflächen der einzelnen mit Kontaktelementgruppen ausgerüstet sind, wobei bei beistimmungsgemäßer Zusammenfügung der Teile die Teilflächen die mit Kontaktelementen bestückten Flächenabschnitte ausbilden. Den verschiedenen Kontaktelementgruppen bilden dabei vorzugsweise entweder die jeweilige Leistungsleitung oder die jeweilige Signalleitung.

Gemäß einem bevorzugten Merkmal der Erfindung ist vorgesehen, dass die wenigstens zwei freien Quaderflächen, vorzugsweise 3, 4 oder 5 freie Quaderflächen, jeweils eine Vielzahl von Kontaktelementen, insbesondere bis zu 56, vorzugsweise bis zu 49, aufweisen, die rasterförmig in Reihen und Spalten, insbesondere in der Konfiguration 7x8 bzw. 7x7, in dem jeweils vorgebbaren Flächenabschnitt angeordnet sind, wobei der jeweilige Flächenabschnitt, gegebenenfalls mit Ausnahme eines jeweils umlaufenden Randes, die gesamte jeweilige Quaderfläche einnimmt. Ein solches Kontaktelement ist auf maximale Stromtragfähigkeit ausgelegt und dazu geeignet, Ströme von bis zu 1000 A zu leiten und darüber hinaus, insbesondere bei Belegung mit unterschiedlichen Leitungen über Kontaktelementgruppen, neben der eigentlichen Leistungsfunktionalität verschiedene auf den Leiterkarten befindliche Diagnosebausteine anzusteuern. Die Kontaktelemente sind dabei vorzugsweise als massive Einpressstifte mit quadratischem oder rundem Querschnitt ausgebildet. Es können jedoch in Abhängigkeit der Stromstärke des zu leitenden Stroms und des gewünschten Funktionsumfangs auch weniger als die Maximalbelegung an Kontaktelementen vorgesehen sein. Tatsächlich ist im Wesentlichen jede beliebige Auswahl an Kontaktelementen aus der Vielzahl der verfügbaren Kontaktelemente, insbesondere den bis zu 56, vorzugsweise den bis zu 49, einer Quaderfläche möglich. So können verschiedenste Belegungen realisiert werden. Eine flexible Anpassung an das jeweilige Schaltungsdesign und die zu leitenden Ströme kann hierdurch in vorteilhafter Weise erreicht werden. Es können besonders bevorzugt 4x4 oder 5x5 Raster mit resultierenden 16 bzw. 25 Kontaktelementen realisiert werden. Ebenso ist es möglich einzelne oder mehrere Reihen und/oder Spalten mit Kontaktelementen zu bestücken. Insbesondere können die jeweils äußeren zwei Spalten und die jeweils äußeren zwei Reihen bestückt werden, um eine umlaufende Reihe aus Kontaktelementen zu erhalten.

Gemäß einer bevorzugten Ausgestaltung der Erfindung ist vorgesehen, dass das zweite freie Ende zylindrisch, insbesondere hohlzylindrisch, ausgebildet ist und zum Zweck der Verbindung mit dem externen Stromkreis ein Außengewinde oder ein Innengewinde aufweist. Der Hochstromkontakt ist hierdurch kompatibel mit den Stromanschlüssen im Bordnetz von Kraftfahrzeugen, die üblicherweise von mechanischen Leistungsrelais genutzt werden. Hierdurch wird ein Ersatz dieser Leistungsrelais ermöglicht.

Gemäß einer bevorzugten Ausgestaltung der Erfindung ist vorgesehen, dass der Grundkörper einen Mittelabschnitt aufweist, der das erste freie Ende und das zweite freie Ende in Längsrichtung miteinander verbindet, wobei der Mittelabschnitt einen Verdrehschutz bereitstellt, indem er wenigstens abschnittsweise mit eckigem Querschnitt, insbesondere rechteckigem Querschnitt, ausgebildet ist. Der Verdrehschutz dient dazu, die bereits mit der Leiterplatte verbundenen Kontaktelementen beim Aufschrauben des Hochstromkontakts auf den stromkreisseitigen korrespondierenden Schraubanschluss von Querkräften freizustellen, die sonst zur Zerstörung der Kontaktelemente führen würde. Gehäuseseitig stellt der Gehäusekörper dabei eine zum eckigen Verdrehschutz korrespondierende Öffnung bereit, in die der Verdrehschutz formschlüssig eingreift.

Gemäß einem weiteren bevorzugten Merkmal der Erfindung ist vorgesehen, dass der Mittelabschnitt einen, insbesondere im Querschnitt kreisförmigen, Flansch zur Anbringung eines, insbesondere induktiven, Strommessgeräts aufweist. Es hat sich in den letzten Jahren der Trend durchgesetzt, immer mehr Verdrahtung auf gedruckten Leiterkarten zu realisieren. Da auch immer mehr Überwachung und Kontrolltechniken verlangt werden, werden immer mehr Sensoren und Messtechnik integriert. Aufgrund des für Hochstromkontakte vergleichsweise hohen Miniaturisierungsgrades besteht die Schwierigkeit elektrische Kenngrößen, wie etwa Stromstärke oder Spannung, welche am Hochstrom-Kontaktelement anliegen zu messen, ohne die Funktion der übrigen, auf der Leiterplatte angeordneten, elektrischen Bauelemente und Baugruppen zu beeinträchtigen. Um Kabel, die oftmals als Anschluss für einen externen Stromkreis, insbesondere das Bordnetz eines Kraftfahrzeugs, mit einer gedruckten Schaltung zu verbinden, wird der Hochstromkontakt verwendet. Der Anschluss des Kabels an den Hochstromkontakt erfolgt vorliegend über das zweite freie Ende des Grundkörpers und kann unterschiedlich ausgeführt sein. In Betracht kommen ein Innen- oder Außengewinde, Schlitze zum Anschrauben oder Stecktechniken. Diese können rund sein oder auch eine andere Geometrie annehmen. Bevorzugt ist die Schraubverbindung über ein Innen- oder Außengewinde. Methoden zur elektrischen Messung physikalischer Größen sind weithin bekannt. Im Allgemeinen spricht man von einer Umsetzung einer zu erfassenden physikalischen Größe (Temperatur, Gewicht, Feuchtigkeit, Spannung, Strom, Widerstand) in eine möglichst proportionale elektrische Größe wie z.B. Spannung oder Strom. Die Ermittlung dieser Größen ist oftmals an den Schnittstellen eines Systems zu seiner Umwelt von Interesse: Wie groß ist der Strom, der über die Anschlüsse des Hochstromkontakts fließt? Wie groß ist der Widerstand des Hochstromkontakts? Zur Messung dieser Größen hat sich die Anordnung eines Strommessgeräts unmittelbar am Hochstromkontakt als besonders vorteilhaft erwiesen. Vorzugsweise handelt es sich hierbei um ein induktives Strommessgerät, welches auf Basis einer Rogowski-Spule, eines Magnetkerns oder eines Magnetfeldsensors arbeitet. Die betreffenden Spulen-, Magnet- oder Sensoranordnungen sind vorzugsweise in einem ringförmigen Gehäuse angeordnet, wobei der Durchmesser des Flanschs mit dem Innendurchmesser des ringförmigen Gehäuses korrespondierend ausgebildet ist, so dass das Gehäuse einfach auf den Flansch aufgesteckt werden und auf diesem Wege daran befestigt werden kann.

Gemäß einem besonders bevorzugten Merkmal der Erfindung ist vorgesehen, dass der Flansch in Längsrichtung des Grundkörpers unmittelbar an das erste freie Ende einerseits und den Verdrehschutz andererseits angrenzt und dass der Verdrehschutz in Längsrichtung des Grundkörpers unmittelbar an den Flansch einerseits und an das zweite freie Ende andererseits angrenzt. Hierdurch ist sichergestellt, dass der Flansch (und damit auch das daran angeordnete Strommessgerät) bei bestimmungsgemäßer Anordnung des Hochstromkontakts im Gehäuse des Halbleiterleistungsrelais im Innenraum des Gehäuses angeordnet ist. In vorteilhafter Weise ist das Strommessgerät damit vor unerwünschten Einwirkungen geschützt. Darüber hinaus dient der Flansch aufgrund seines im Vergleich zum zweiten freien Ende größeren Durchmessers als Stabilisierungselement für das erste freie Ende, welches wiederum eine gegenüber dem Flansch größere Querschnittsbreite aufweist.

Mit Bezug auf das erfindungsgemäße Halbleiterleistungsrelais ist bevorzugt vorgesehen, dass das Gehäuse einen als Stranggussprofil ausgebildeten Gehäusekörper, insbesondere mit außenseitigen Kühlrippen, aufweist, welcher einen Innenraum und den Innenraum nach außen hin begrenzende Gehäusewände bereitstellt, wobei die Leiterplatte/n und das erste freie Ende des Hochstromkontakts im Innenraum angeordnet sind und wobei das zweite freie Ende außerhalb des Gehäuses angeordnet ist, wobei der Gehäusekörper zu diesem Zweck eine Öffnung bereitstellt, welche eine Gehäusewand vollständig durchgreift. Durch die Ausbildung des Gehäusekörpers als Stranggussprofil mit Kühlrippen, wird die notwendige Ableitung der beim Betrieb des Halbleiterleistungsrelais entstehenden Wärme gewährleistet.

Das Halbleiterleistungsrelais gemäß der Erfindung kann einteilig oder zweiteilig ausgebildet sein. Bei der einteiligen Ausgestaltung umfasst die Leistungstransistorbaugruppe den Leistungsteil und die Ansteuerung. Der Platzbedarf ist hierdurch geringer. Allerdings muss in diesem Fall, im Vorfeld bekannt sein, wie die Leistungstransistorbaugruppe angesteuert werden soll. Alternativ kann das Halbleiterleistungsrelais zweiteilig ausgebildet sein. In diesem Fall sind Leistungsteil und Ansteuerung voneinander getrennt. Die Ansteuerung ist in ein gesondertes Modul ausgegliedert, dass im Nachgang aufgesteckt werden und entsprechend den Anforderungen konfiguriert werden kann. Hierdurch kann eine Steuerung über Spannungs- / Stromsignale oder digitale Werte implementiert werden. Eine PWM-Ansteuerung oder Strombegrenzung als Leitungsschutz sind ebenfalls realisierbar. Hierdurch kann eine vorteilhafte galvanische Trennung der Ansteuerung, insbesondere über Optokoppler, induktive oder optische Signale, erreicht werden. Zusätzlich oder alternativ ist eine Kopplung mit Bussystemen wie zum Beispiel CAN/LIN/Ethernet herstellbar. Das Modul stellt zur Aufnahme der Steuerungselektronikvorzugsweise ein eigenes Gehäuse bereit.

Nachfolgend wird die Erfindung anhand von Ausführungsbeispielen verdeutlicht.

Dabei zeigen
- Fig.1: einen ersten Hochstromkontakt gemäß der Erfindung in seitlicher Darstellung
- Fig.2: den ersten Hochstromkontakt gemäß Figur 1 in perspektivischer Darstellung;
- Fig.3: einen zweiten Hochstromkontakt gemäß der Erfindung in perspektivischer Darstellung;
- Fig.4: eine Halbleiterleistungsrelaisschaltung mit montierten Hochstromkontakten gemäß der Erfindung;
- Fig.5: ein erstes Halbleiterleistungsrelais gemäß der Erfindung im Längsschnitt;
- Fig.6: das Halbleiterleistungsrelais gemäß Figur 5 in perspektivischer Darstellung;
- Fig.7: das Halbleiterleistungsrelais gemäß Figur 7 in perspektivischer Darstellung;
- Fig.8: ein zweites Halbleiterleistungsrelais gemäß der Erfindung im Längsschnitt;
- Fig.9: zwei Halbleiterleistungsrelais gemäß der Erfindung mit alternativer Ausgestaltung der zweiten freien Enden des Grundkörpers des Hochstromkontakts;
- Fig.10: eine Quaderfläche mit verschiedenen Beispielen für die Anordnung von Kontaktelementen auf der Quaderfläche in Aufsicht.

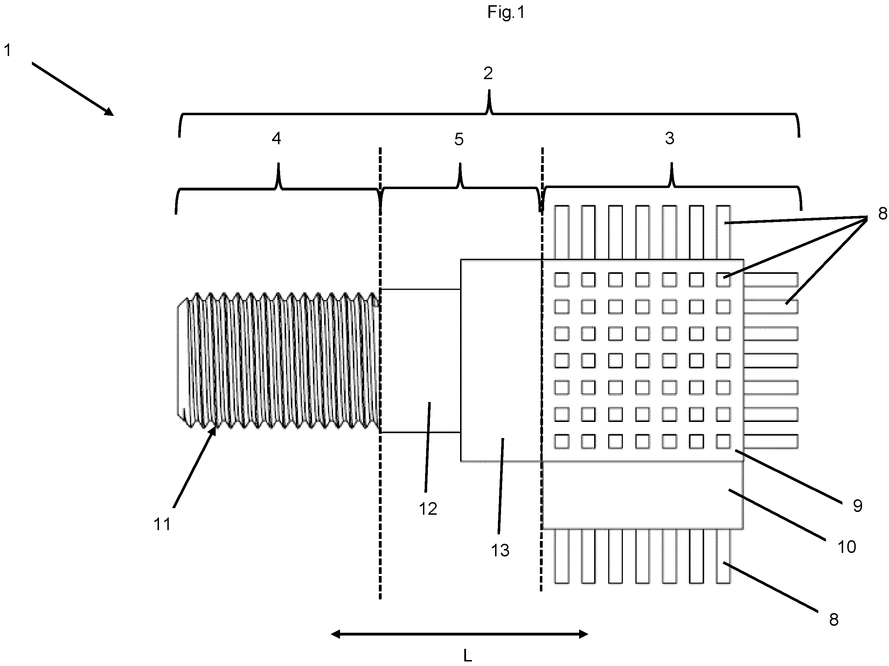

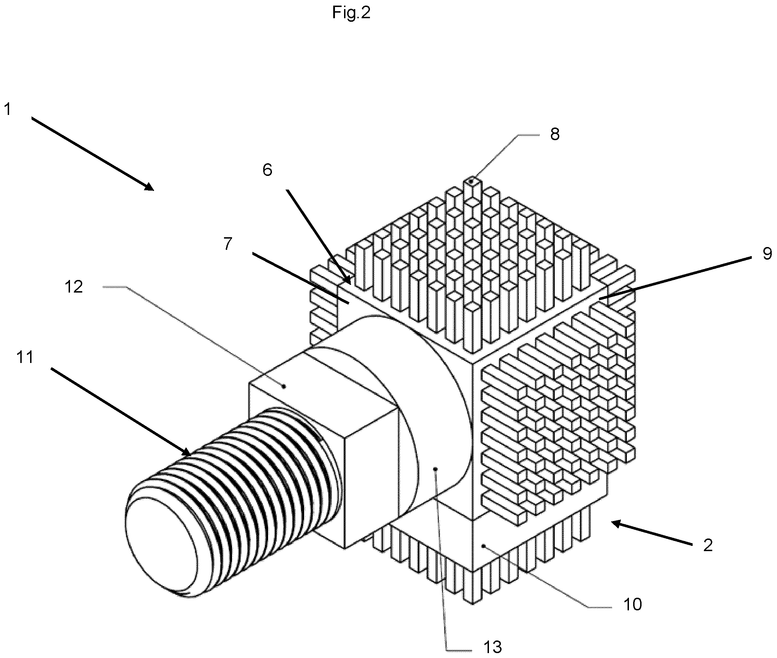

Figuren 1 und 2 zeigen einen ersten Hochstromkontakt 1 gemäß der Erfindung. Er ist vorliegend gebildet aus einem länglichen Grundkörper 2. Der Grundkörper 2 weist in Längsrichtung L ein erstes freies Ende 3, ein zweites freies Ende 4 sowie einen Mittelabschnitt 5 auf, welcher die beiden freien Enden 3, 4 in Längsrichtung miteinander verbindet.

Das erste freie Ende 3 ist polyedrisch, vorliegend quaderförmig ausgebildet. Es verfügt damit über sechs Polyederflächen, vorliegend Quaderflächen. Fünf der Quaderflächen sind freie Quaderflächen 6. Die sechste Quaderfläche 7 ist über den Mittelabschnitt 5 mit dem zweiten freien Ende 4 verbunden. Jeder der fünf freien Quaderflächen 6 ist mit einer Vielzahl, vorliegend jeweils 49, Kontaktelementen in Form von massiven Einpressstiften 8 bestückt. Die Einpressstifte sind dabei in Reihen und Spalten von jeweils sieben rasterförmig in einem Flächenabschnitt verteilt angeordnet und stehen lotrecht auf der jeweiligen Quaderfläche 6. Mit Blick auf die Zeichenebene nimmt der jeweilige mit Einpressstiften bestückte Flächenabschnitt der oberen und unteren Quaderfläche mit Ausnahme eines umlaufenden Randabschnitts die gesamte Quaderfläche 6 ein.

Im Unterschied dazu nimmt der jeweilige mit Einpressstiften bestückte Flächenabschnitt 9 der übrigen Quaderflächen 6 nur 75 % der zur Verfügung stehenden Fläche ein. Die verbleibenden 25 % der jeweiligen Quaderflächen 6 wird von einem kontaktelementfreien bzw. einpressstiftfreien Flächenabschnitt 10 eingenommen. Diese Abschnitte 10 können bei der Montage des Hochstromkontakts 1 auf einer Leiterplatte im Wege der Einpresstechnik mit einem Pressstempel zusammen, um auf die jeweils gegenüberliegenden Einpressstifte 8 eine axiale Kraft zu übertragen. Ferner kann auch der Flächenabschnitt 10 dazu genutzt werden, um eine Strommessung vorzunehmen. Zu diesem Zweck kann eine entsprechende Messvorrichtung, insbesondere eine Messspule an dem Flächenabschnitt 10 angeordnet werden.

Das zweite Ende 4 ist zylindrisch mit kreisförmigem Querschnitt ausgebildet. Es ist überdies mit einem Außengewinde 11 versehen, um an einen korrespondierenden Anschluss eines externen Stromkreises, insbesondere dem Bordnetz eines Kraftfahrzeugs, angeschlossen zu werden. Ferner werden hierdurch die Anschlüsse eines mechanischen kontaktbehafteten Leistungsrelais nachgebildet, das es zu ersetzen gilt.

Der Mittelabschnitt 5 weist einen Verdrehschutz 12 zum Schutz der Einpressstifte 8 während der Montage und einen Flansch 13 zur Anordnung eines ringförmigen Strommessgeräts auf.

Der Stromfluss verläuft dabei im bestimmungsgemäßen Verwendungsfall vom externen Stromkreis in das zweite freie Ende 4, über den Mittelabschnitt 5 in das erste freie Ende 3 und von den Einpressstiften 8 in die korrespondierenden Kontaktzonen eines zugeordneten Kontaktbereichs der Leiterplatte und von dort zum Leistungstransistor. Auf der Ausgangsseite des Leistungstransistors verläuft der Stromfluss dabei im bestimmungsgemäßen Verwendungsfall genau umgekehrt, also vom Leistungstransistor zu Kontaktzonen eines Kontaktbereichs der Leiterplatte, von dort in die korrespondierende Einpressstiften 8 des freien Endes 3 und über den Mittelabschnitt 5 und das freie Ende 4 wieder zurück zum externen Stromkreis.

Für die prinzipielle Funktionsweise des Hochstromkontakts 1 sind der Verdrehschutz 12 und/oder der Flansch 13 nicht erforderlich. Sie dienen der vorbeschriebenen Erweiterung des Funktionsumfangs des Hochstromkontakts 1. Prinzipiell ist daher auch eine solche Ausgestaltung erfindungsgemäß, bei der unter Verzicht auf den Mittelabschnitt 5, das erste freie Ende 3 und das zweite freie Ende 4 unmittelbar miteinander in Kontakt stehen.

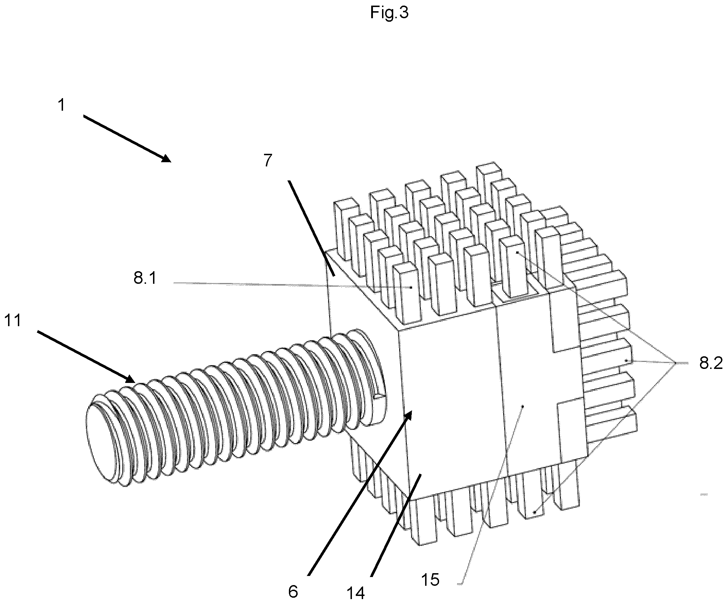

Figur 3 zeigt einen zweiten Hochstromkontakt 1 gemäß der Erfindung. Er ist vorliegend ebenso wie in Figur 1 dargestellt gebildet aus einem länglichen Grundkörper 2. Der Grundkörper 2 weist in Längsrichtung ein erstes freies Ende 3 und ein zweites freies Ende 4 auf. Ein Mittelabschnitt 5 wie er in der Ausgestaltung nach Figuren 1 und 2 zu erkennen war, fehlt im vorliegenden Ausführungsbeispiel. Stattdessen sind das erste freie Ende 3 und das zweite freie Ende 4 in Längsrichtung des Grundkörpers unmittelbar miteinander verbunden.

Das erste freie Ende 3 ist kubisch bzw. würfelförmig mit sechs Kubusflächen ausgebildet. Fünf der Kubusflächen sind freie Quaderflächen 6. Die sechste Quaderfläche 7 ist unmittelbar mit dem zweiten freien Ende 4 verbunden. Drei der fünf freien Quaderflächen 6 sind mit einer Vielzahl, vorliegend jeweils 25, Kontaktelementen in Form von massiven Einpressstiften 8 bestückt. Die Einpressstifte 8 sind dabei in Reihen und Spalten von jeweils fünf rasterförmig in einem Flächenabschnitt verteilt angeordnet und stehen lotrecht auf der jeweiligen Quaderfläche 6. Die jeweiligen mit Einpressstiften bestückten Flächenabschnitte der oberen, unteren und rechten freien Quaderfläche 6 nehmen mit Ausnahme eines umlaufenden Randabschnitts die gesamte Quaderfläche 6 ein.

Im Unterschied dazu sind die verbleibenden freien hinteren und vorderen Quaderflächen 6 vollständig kontaktelementfrei bzw. einpressstiftfrei ausgebildet. Dabei ist zu erkennen, dass das erste freie Ende 3 zweiteilig ausgebildet ist, wobei beide Teile 14, 15 zusammen die Quaderform und die zugehörigen Quaderflächen 6 ausbilden. Die einzelnen Teil 14, 15 sind jeweils mit Einpressstiften 8.1 und 8.2 bestückt, die unterschiedlichen Zwecken dienen. Während die Einpressstifte 8.1 Teil der Leistungsleitung bilden, sind die Einpressstifte 8.2 Teil einer Signalleitung, die der Ansteuerung des Leistungstransistors und/oder der datentechnischen Verbindung mit Diagnoseeinheiten dient.

Das zweite Ende 4 ist zylindrisch mit kreisförmigem Querschnitt ausgebildet. Es ist überdies mit einem Außengewinde 11 versehen, um an einen korrespondierenden Anschluss eines externen Stromkreises, insbesondere dem Bordnetz eines Kraftfahrzeugs, angeschlossen zu werden.

Der Stromfluss verläuft dabei im bestimmungsgemäßen Verwendungsfall auf der Eingangsseite des Leistungstransistors bzw. der Leistungstransistoren vom externen Stromkreis in das zweite freie Ende 4, direkt in das erste freie Ende 3 und von den Einpressstiften 8.1, 8.2 in die korrespondierenden Kontaktzonen eines zugeordneten Kontaktbereichs der Leiterplatte und von dort zum Leistungstransistor bzw. einer Diagnoseeinheit. Auf der Ausgangsseite des Leistungstransistors verläuft der Stromfluss dabei im bestimmungsgemäßen Verwendungsfall genau umgekehrt, also vom Leistungstransistor bzw. den Leistungstransistoren zu Kontaktzonen eines oder mehrerer Kontaktbereiche der Leiterplatte, von dort in die korrespondierende Einpressstiften 8 des freien Endes 3 und über das freie Ende 4 wieder zurück zum externen Stromkreis.

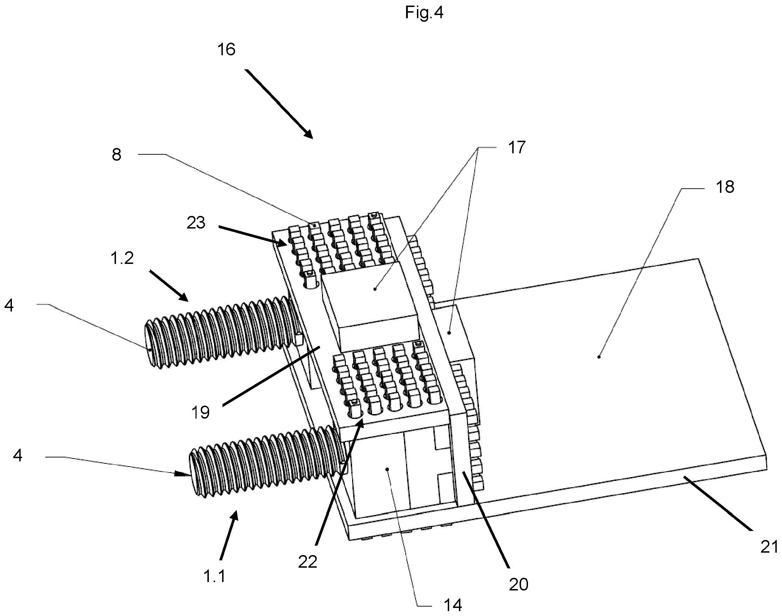

Figur 4 zeigt eine Halbleiterschaltungsanordnung 16 bei der mittels zweier Hochstromkontakte 1.1, 1.2 gemäß der in Figur 3 gezeigten Ausführungsform drei Leistungstransistoren 17 welche auf zwei verschiedenen Leiterplatten 18, 19 angeordnet sind, parallelgeschaltet sind.

Die Leiterplatte 18 ist dabei dreidimensional ausgebildet mit einem im Wesentlichen T-förmigen Querschnitt. Dabei steht ein erster Plattenabschnitt 20 lotrecht auf einem zweiten Plattenabschnitt 21. Die Leiterplatte 19 ist hingegen zweidimensional ausgebildet.

Die Leiterplatte 19 sowie die beiden Plattenabschnitte 20, 21 stellen jeweils unmittelbar aneinander angrenzend einen ersten gelochten Kontaktbereich 22 zur Aufnahme der Einpressstifte 8 des eingangsseitigen Hochstromkontakts 1.1, einen Leistungstransistor 17 und einen zweiten gelochten Kontaktbereich 23 zur Aufnahme der Einpressstifte 8 des ausgangsseitigen Hochstromkontakts 1.2 bereit. Die Anbindung der Leiterkarten 18, 19 an die Hochstromkontakte 1.1, 1.2 erfolgt ersichtlicherweise in drei Raumrichtungen. Es werden hierdurch kürzeste Wege zwischen den Kontakten und den Leistungstransistoren erreicht, wodurch Spannungsabfälle und Wärmeentwicklung weitgehend vermieden werden. Ferner wird auf kleinstem Raum die Schaltung hoher Ströme durch dreidimensionale Parallelschaltung von mehreren Leistungstransistoren erreicht. Ein dritter parallelgeschalteter Leistungstransistor 17 (nicht dargestellt) ist auf der mit Bezug auf die Zeichenebene Unterseite des Plattenabschnitts 21 angeordnet. Anstelle der dreidimensionalen Leiterplatte 19 können z.B. auch zwei zweidimensionale Leiterplatten mit entsprechender Bestückung mit einem oder mehreren Leistungstransistoren mit den Hochstromkontakten 1.1, 1.2 verbunden werden.

Eine solche Halbleiterschaltungsanordnung 16 bildet zusammen mit einem entsprechenden Gehäuse ein Halbleiterleistungsrelais 24 im Sinne der Erfindung.

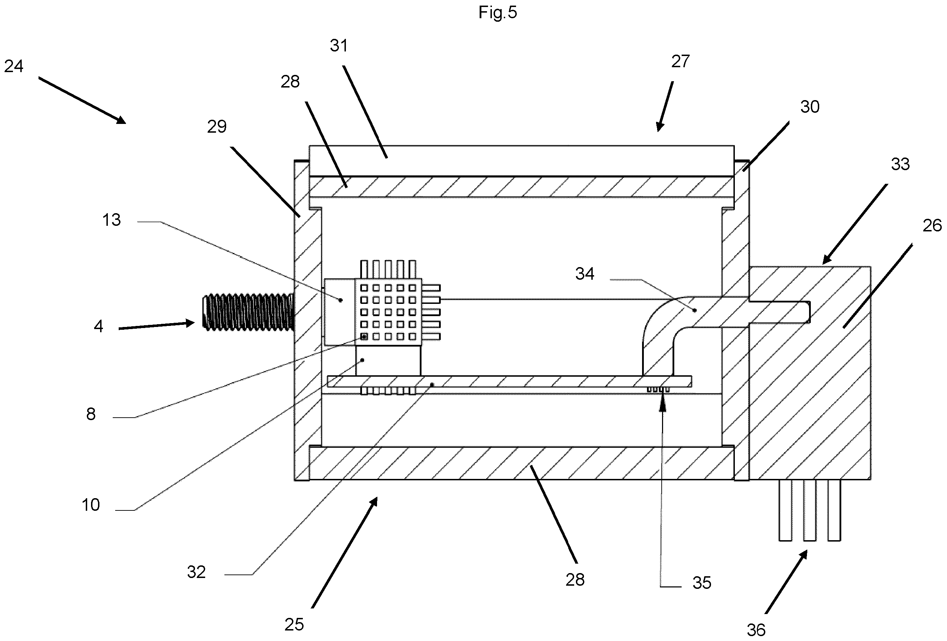

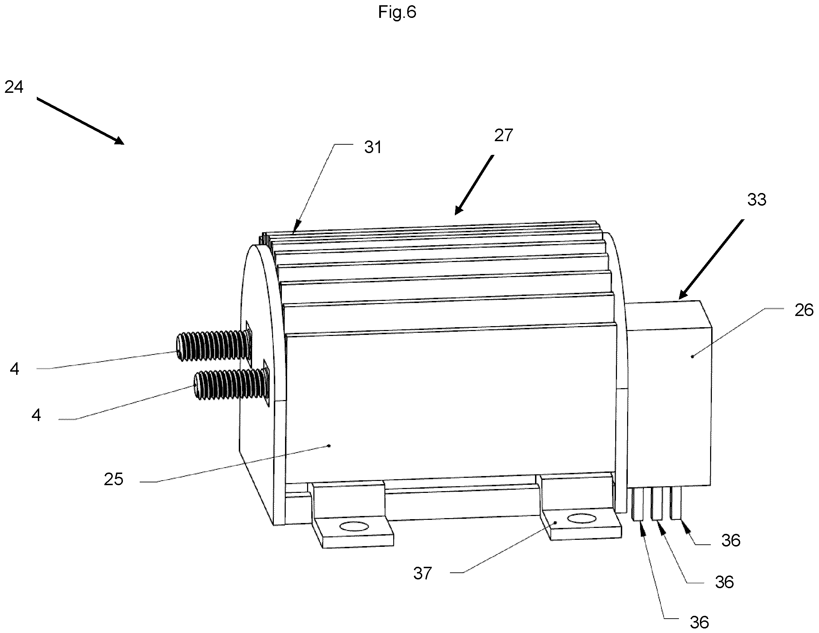

Die Figuren 5 und 6 zeigen ein solches Halbleiterleistungsrelais 24 im Längsschnitt und in perspektivischer Außendarstellung.

Zu erkennen ist eine zweiteilige Ausführung des Halbleiterleistungsrelais 24 Dabei werden Leistungsteil und Ansteuerung in zwei getrennten Modulen 25, 26 beherbergt. Das Leistungsmodul weist ein Gehäuse 27 mit einem Gehäusekörper 28 auf, der als Stranggussprofil ausgebildet ist und vorne und hinten von Abschlussplatten 29, 30 verschlossen wird. Oberseitig sind ferner Kühlrippen 31 zu erkennen.

Dargestellt sind zwei Hochstromkontakte 1.1, 1.2, welche mittels Einpresstechnik mit zunächst einer Leiterplatte 32 leitungstechnisch verbunden ist. Die Leiterplatte 32 trägt einen Leistungstransistor, welcher eingangsseitig und ausgangsseitig leitungstechnisch jeweils mit einem der beiden Hochstromkontakte 1.1, 1.2 verbunden ist.

Dargestellt ist ferner ein Steuermodul 26 mit eigenem Gehäuse 33. Das dient der Ansteuerung des Leistungstransistors und ist mittels eines Kabels 34 mit dem Leiterplatte leitungstechnisch verbunden. Die Verbindung erfolgt über eine Steckverbindung 35 Das Steuermodul 26 verfügt über eigene Steckanschlüsse 36 zur Verbindung mit einem externen Stromkreis. Das Gehäuse 27 verfügt vorliegend über Halter 37, die durch eine Schwalbenschwanzführung im Nachgang montiert werden können. Die untere Grundplatte des Gehäusekörpers 28 ist plan ausgeführt, um eine optimale Wärmeübergang zu einer nicht dargestellten Montageplatte oder in die Leiterplatte 32 zu ermöglichen.

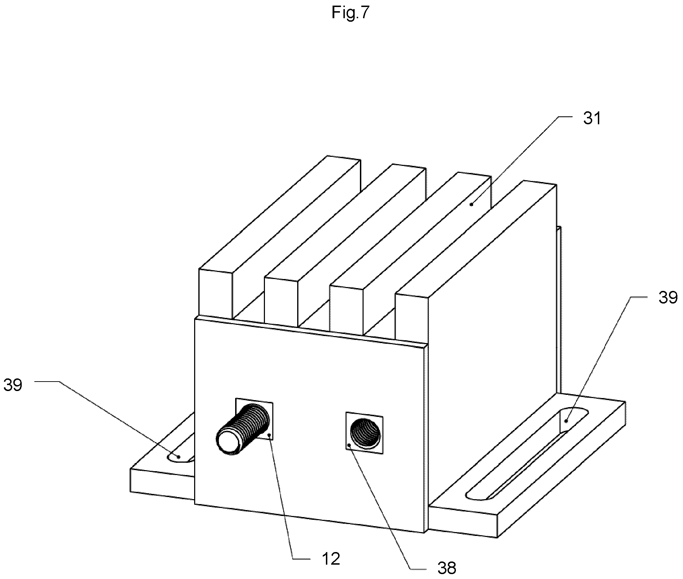

In Figur 7 ist eine alternative Ausgestaltung der Erfindung gezeigt. Im Gegensatz zu der Ausführung nach Figuren 5 und 6 weist das stromeingangsseitige Hochstromkontakt 1 ein zweites freies Ende 4 mit einem Innengewinde auf. Ferner zu erkennen ist eine abweichende Gehäuseform mit jeweils einem Verdrehschutz 12 und einer korrespondierenden Öffnung 38 in der Abschlussplatte 29 dargestellt. Das vorliegende Gehäuse weist anstelle der Halter 37 zur nachträglichen Montage auf einer Montageplatte Nuten bzw. Langlöcher 39 auf.

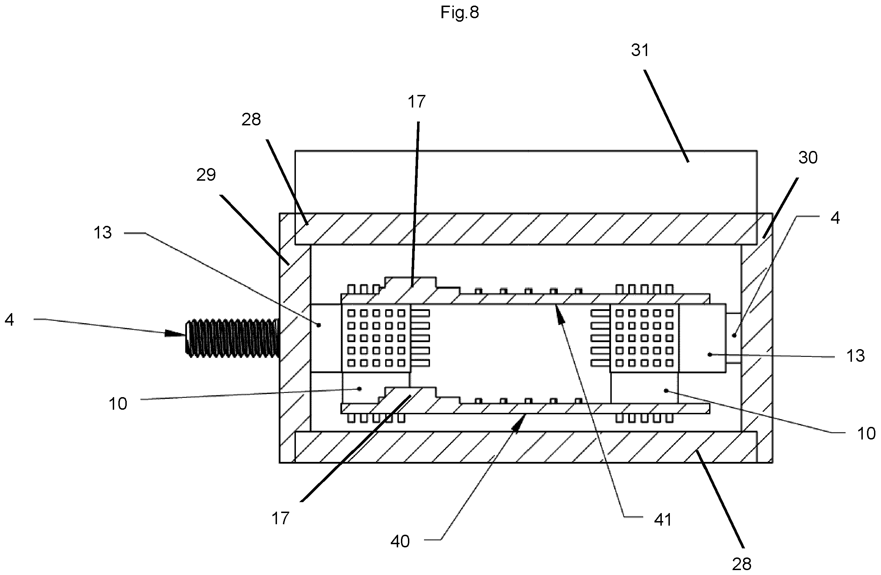

Figur 8 zeigt eine alternative Ausgestaltung eines erfindungsgemäßen Halbleiterleistungsrelais 24 im Längsschnitt und in perspektivischer Außendarstellung.

Im Wesentlichen unterscheidet sich diese Ausgestaltung von derjenigen gemäß Figuren 5 und 6 dadurch, dass die beiden Hochstromkontakte 1.1, 1.2 , welche zwei Leistungstransistoren 17, welche auf parallelverlaufenden Leiterplatten 40, 41 angeordnet sind, parallelschalten, nicht in Breitenrichtung der Leiterplatten 40, 41 nebeneinander, sondern in Längsrichtung der Leiterplatten 40, 41 hintereinander angeordnet sind. Die jeweilige freien Enden 4 ragen damit nicht durch die gleiche Abschlussplatte 29 hinaus, sondern auf gegenüberliegenden Abschlussplatten 29, 30. Der stromeingangsseitige mit Bezug auf die Bildebene linke Hochstromkontakt 1.1 weist ein zweites freie Ende 4 auf, das mit Außengewinde ausgebildet ist und durch die Abschlussplatte 29 geführt ist, während der stromausgangsseitige mit Bezug auf die Bildebene rechte Hochstromkontakt 1.2 ein zweites freie Ende 4 aufweist, welches mit einem Innengewinde ausgebildet ist und durch die Abschlussplatte 30 geführt ist.

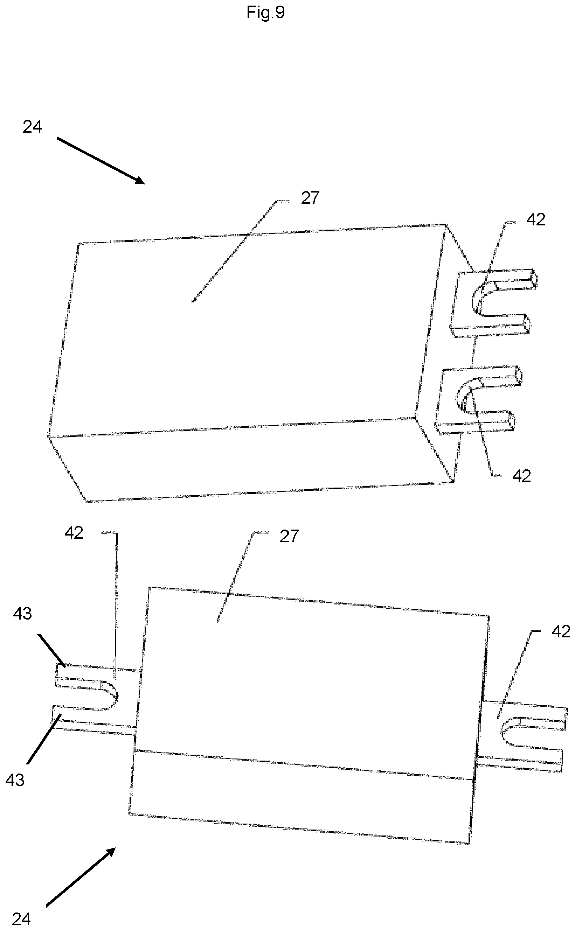

Die in den vorangegangenen Figuren gezeigte Möglichkeit, Form, Anzahl und Ausrichtung der zweiten freien Enden 4 der Hochstromkontakte des Halbleiterleistungsrelais 24 zu variieren und/oder zweite freien Enden 4 der Hochstromkontakte parallel (Fig. 4-6) oder hintereinander (Fig.7) anzuordnen führt zu einer Reihe von Vorteilen. So kann das Halbleiterleistungsrelais 24 in der Ausgestaltung nach Figur 7 beispielsweise in Reihe in einen Kabelstrang montiert werden oder in der Ausgestaltung nach Figuren 4-6 die zweiten freien Enden 4 auf einer Verteilerleiterplatte montiert werden. Figur 9 zeigt zwei weitere alternative Ausgestaltungen eines erfindungsgemäßen Halbleiterleistungsrelais 24 in jeweils perspektivischer Außendarstellung. Der Unterschied liegt zum einen in der Ausgestaltung der jeweiligen zweiten freien Enden 4 des Grundkörpers 2 der Hochstromkontakte 1.1, 1.2. Diese sind anstatt mit einem Außen- oder Innengewinde jeweils als U-förmiger Stecker 42 mit zwei parallel verlaufenden Schenkeln 43 ausgebildet. Diese Ausgestaltung erlaubt die Verbindung mit einem anderen Typus von Stromanschluss, der ebenfalls von manchen mechanischen Leistungsrelais genutzt wird.

Ferner unterscheidet sich die beiden alternativen Ausgestaltungen voneinander, indem die Hochstromkontakte 1.1, 1.2 einmal an der gleichen Seite (In Entsprechung der Ausgestaltungen gemäß Figuren 4 bis 6) aus dem Gehäuse 27 geführt sind und ein andermal an einander gegenüber liegenden Seiten (in Entsprechung der Figur 7). Hierdurch können wie oben erläutert unterschiedliche Anschlussgeometrien verwirklicht und den Anschluss an einen externen Stromkreis, insbesondere eine Verteilerleiterplatte erleichtert werden.

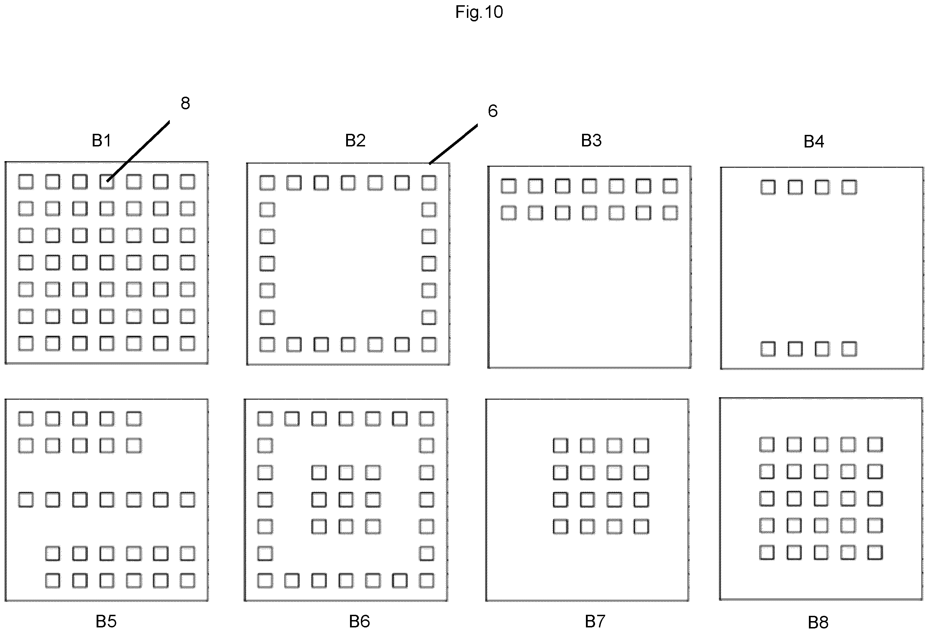

Figur 10 zeigt verschiedene Belegungen B1 bis B8 einer Quaderfläche 6 des Hochstromkontakts mit Kontaktelementen 8. Je nach gewünschtem Funktionsumfang und der Stromstärke des zu leitenden Stroms kann die Geometrie der Anordnung variieren. Maximal belegbar bzw. anordenbar sind pro freier Quaderfläche 6 insgesamt 49 Kontaktelemente 8. Die Anzahl der Kontaktelemente 8 korreliert dabei positiv mit der Stromtragfähigkeit. Aus dieser maximalen Anzahl kann eine gewünschte Belegung ausgewählt werden. Die Belegungen B1 bis B8 sind dabei lediglich exemplarisch zu verstehen. Je nach Schaltungsdesign können weitere Belegungen ausgewählt werden. Neben den gezeigten Belegungen ist darüber in Abhängigkeit der gewünschten Stromtragfähigkeit hinaus denkbar, die Anzahl der Kontaktelemente 8 über 49 hinaus zu erhöhen, insbesondere bis zu 56. Neben der quadratischen Form der Quaderfläche 6 sind darüber hinaus auch von der Quadratform abweichende eckige Flächenformen denkbar, insbesondere rechteckig, sechseckig usw.

### Bezugszeichenliste

- 1: Hochstromkontakt
- 1.1: erster Hochstromkontakt
- 1.2: zweiter Hochstromkontakt
- 2: Grundkörper
- 3: Erstes freies Ende
- 4: Zweites freies Ende
- 5: Mittelabschnitt
- 6: Freie Quaderflächen
- 7: Quaderfläche
- 8: Einpressstifte
- 8.1: Gruppe von Einpressstiften
- 8.2: Gruppe von Einpressstiften
- 9: Flächenabschnitt
- 10: Flächenabschnitt
- 11: Außengewinde
- 12: Verdrehschutz
- 13: Flansch
- 14: Quaderteil
- 15: Quaderteil
- 16: Halbleiterschaltungsanordnung
- 17: Leistungstransistor
- 18: Leiterplatte
- 19: Leiterplatte
- 20: Plattenabschnitt
- 21: Plattenabschnitt
- 22: Kontaktbereich
- 23: Kontaktbereich
- 24: Halbleiterleistungsrelais
- 25: Modul
- 26: Modul
- 27: Gehäuse
- 28: Gehäusekörper
- 29: Abschlussplatte
- 30: Abschlussplatte
- 31: Kühlrippen
- 32: Leiterplatte
- 33: Gehäuse
- 34: Kabel
- 35: Steckverbindung
- 36: Steckanschlüsse
- 37: Halter
- 38: Öffnung
- 39: Langloch
- 40: Leiterplatte
- 41: Leiterplatte
- 42: Stecker
- 43: Schenkel

- L: Längsrichtung
- B1: Belegung 1
- B2: Belegung 2
- B3: Belegung 3
- B4: Belegung 4
- B5: Belegung 5
- B6: Belegung 6
- B7: Belegung 7
- B8: Belegung 8

## Patentansprüche

1. Hochstromkontakt zur elektrischen Verbindung einer Leiterplatte eines Halbleiterleistungsrelais mit einem externen Stromkreis, insbesondere dem Bordnetz eines Kraftfahrzeugs, gebildet aus einem dreidimensionalen Grundkörper, dessen Länge seine übrigen Abmessungen übersteigt, wobei der Grundkörper ein in Längsrichtung erstes freies Ende und ein dem ersten freien Ende gegenüber liegendes zweites freies Ende aufweist, wobei das erste freie Ende der elektrischen Verbindung mit der Leiterplatte dient und wobei das zweite freie Ende der elektrischen Verbindung mit dem externen Stromkreis dient, wobei das erste freie Ende mit polyedrischer Form, ausgebildet ist, **dadurch gekennzeichnet, dass** das erste freie Ende zur elektrischen Verbindung mit der Leiterplatte wenigstens zwei elektrisch leitfähige Kontaktelemente aufweist, die sich jeweils von einer der Polyederfläche des ersten freien Endes aus in voneinander verschiedene Raumrichtungen erstrecken.

2. Hochstromkontakt nach Anspruch 1, **dadurch gekennzeichnet, dass** jedes Kontaktelement auf einer separaten Polyederseite angeordnet ist und sich entlang der Flächennormalen der jeweiligen Polyederfläche erstreckt.

3. Hochstromkontakt nach einem der Ansprüche 1 oder 2, **dadurch gekennzeichnet, dass** die Kontaktelemente jeweils durch wenigstens einen Schraubkontakt, einen Lötstift oder einen Einpressstift gebildet sind.

4. Hochstromkontakt nach einem der Ansprüche 1 bis 3, **dadurch gekennzeichnet, dass** das erste freie Ende mit polyedrischer, insbesondere quaderförmiger, Form ausgebildet ist, wobei eine der Polyederflächen, insbesondere der sechs Quaderflächen, des ersten Endes mit dem zweiten freien Ende verbunden ist und die übrigen Polyederflächen, insbesondere die übrigen fünf Quaderflächen, freie Polyederflächen, insbesondere Quaderflächen, bilden, wobei wenigstens zwei der freien Polyederflächen, insbesondere Quaderflächen, jeweils eine Vielzahl von Kontaktelementen in Form von Löt- und/oder Einpressstiften aufweisen, die lotrecht auf der jeweiligen freien Polyederfläche, insbesondere Quaderfläche, stehen und innerhalb eines vorgebbaren Flächenabschnitts der jeweiligen Polyederfläche, insbesondere Quaderfläche, regelmäßig verteilt angeordnet sind.

5. Hochstromkontakt nach einem der Ansprüche 1 bis 4, **dadurch gekennzeichnet, dass** in den Grundkörper eine Leistungsleitung zur elektrischen Ansteuerung eines Leistungstransistors auf der Leiterplatte des Halbleiterleistungsrelais und eine Signalleitung für die datentechnische Verbindung mit Diagnoseeinheiten integriert sind, wobei für die jeweilige Verbindung Kontaktelemente verschiedener freier Polyederflächen, insbesondere Quaderflächen, und/oder einzelne Kontaktelemente und/oder eine Mehrzahl von Kontaktelementen der gleichen Polyederfläche, insbesondere Quaderfläche, zu wenigstens einer Leistungsleitungsgruppe und einer Diagnoseleitungsgruppe gruppiert sind.

6. Hochstromkontakt nach einem der Ansprüche 4 oder 5, **dadurch gekennzeichnet, dass** erste freie Ende quaderförmig ausgebildet ist und wenigstens zwei freie Quaderflächen jeweils mit einer Vielzahl von Kontaktelementen bestückt sind, wobei die beiden mit Kontaktelementen bestückten freien Quaderflächen einander gegenüberliegend angeordnet sind oder die beiden mit Kontaktelementen bestückten freien Quaderflächen eine gemeinsame Quaderkante zwischen sich ausbilden und sich im rechten Winkel zueinander erstrecken, wobei eine der mit Kontaktelementen bestückten freien Quaderflächen derjenigen Quaderfläche gegenüberliegend angeordnet ist, die mit dem zweiten freien Ende verbunden ist.

7. Hochstromkontakt nach Anspruch 6, **dadurch gekennzeichnet, dass** alle fünf freien Quaderflächen jeweils eine Vielzahl von elektrischen Kontaktelementen in Form von Löt- und/oder Einpressstiften aufweisen, die lotrecht auf der jeweiligen freien Quaderfläche stehen und innerhalb eines vorgebbaren Flächenabschnitts der jeweiligen Quaderfläche regelmäßig verteilt angeordnet sind.

8. Hochstromkontakt nach einem der Ansprüche 5 bis 7, **dadurch gekennzeichnet, dass** das zweite freie Ende zylindrisch, insbesondere hohlzylindrisch, ausgebildet ist und zum Zweck der Verbindung mit dem externen Stromkreis ein Außengewinde oder ein Innengewinde aufweist.

9. Hochstromkontakt nach Anspruch 8, **dadurch gekennzeichnet, dass** der Grundkörper einen Mittelabschnitt aufweist, der das erste freie Ende und das zweite freie Ende in Längsrichtung miteinander verbindet, wobei der Mittelabschnitt einen Verdrehschutz bereitstellt, indem er wenigstens abschnittsweise mit eckigem Querschnitt, insbesondere rechteckigem Querschnitt, ausgebildet ist.

10. Hochstromkontakt nach Anspruch 9, **dadurch gekennzeichnet, dass** der Mittelabschnitt einen, insbesondere im Querschnitt kreisförmigen, Flansch zur Anbringung eines, insbesondere induktiven, Strommessgeräts aufweist.

11. Hochstromkontakt nach Anspruch 10, **dadurch gekennzeichnet, dass** der Flansch in Längsrichtung des Grundkörpers unmittelbar an das erste freie Ende einerseits und den Verdrehschutz andererseits angrenzt und dass der Verdrehschutz in Längsrichtung des Grundkörpers unmittelbar an den Flansch einerseits und an das zweite freie Ende andererseits angrenzt.

12. Hochstromkontakt nach einem der Ansprüche 1 bis 11, **dadurch gekennzeichnet, dass** eine freie Quaderfläche, die einer mit Kontaktelementen in Form von Einpressstiften bestückten Quaderfläche gegenüberliegend angeordnet ist, einen kontaktelementfreien Flächenabschnitt aufweist, welcher der Kraftaufnahme und der diesbezüglichen Kontaktierung mit einem Presswerkzeug während des Einpressens der Kontaktelemente der gegenüberliegenden freien Quaderfläche in die Leiterplatte dient und/oder welcher der Befestigung eines, insbesondere induktiven, Strommessgeräts dient.

13. Halbleiterleistungsrelais, insbesondere KFZ-Halbleiterleistungsrelais, mit wenigstens einem Hochstromkontakt nach einem der Ansprüche 1 bis 12, wenigstens einer Leistungstransistorschaltung und einem Gehäuse zur Aufnahme des Hochstromkontakts und der Leistungstransistorschaltung, wobei die Leistungstransistorschaltung wenigstens zwei mittels des Hochstromkontakts parallel geschaltete Leistungstransistoren, insbesondere in Form von Leistungs-MOSFETs, aufweist, wobei die wenigstens zwei Leistungstransistoren auf einer einzigen, insbesondere dreidimensionalen, Leiterplatte oder zwei verschiedenen Leiterplatten angeordnet sind, wobei jeder Leistungstransistor leitungstechnisch mit einem eigenen flächigen Kontaktabschnitt verbunden ist, der von der wenigstens einen Leiterplatte bereitgestellt ist, wobei jeweils ein Kontaktabschnitt jeweils einer freien Polyederfläche, insbesondere Quaderfläche, des ersten freien Endes des Hochstromkontakts zugeordnet und mit dieser durch zumindest eines jeweiligen Kontaktelemente mechanisch und leitungstechnisch durch Löten, verschrauben oder Einpressen verbunden ist.

14. Halbleiterleistungsrelais nach Anspruch 13, **dadurch gekennzeichnet, dass** das Gehäuse einen als Stranggussprofil ausgebildeten Gehäusekörper, insbesondere mit außenseitigen Kühlrippen, aufweist, welcher einen Innenraum und den Innenraum nach außen hin begrenzende Gehäusewände bereitstellt, wobei die Leiterplatte/n und das erste freie Ende des Hochstromkontakts im Innenraum angeordnet sind und wobei das zweite freie Ende außerhalb des Gehäuses angeordnet ist, wobei der Gehäusekörper zu diesem Zweck eine Öffnung bereitstellt, welche eine Gehäusewand vollständig durchgreift.

15. System mit einem Halbleiterleistungsrelais nach einem der Ansprüche 13 oder 14 und einem Steuermodul mit einem separaten Gehäuse, wobei das Steuermodul leitungstechnisch, insbesondere mittels eines Hochstromkontakts nach einem der Ansprüche 1 bis 12, mit wenigstens einer der Leiterplatten des Halbleiterleistungsrelais verbunden ist.
